# EUROPEAN PATENT SPECIFICATION

(11) **EP 3 336 991 B1**
(45) Date of publication and mention of the grant of the patent: **06.10.2021**
(21) Application number: 16205023.1
(22) Date of filing: 19.12.2016
(51) Int. Cl.: H02G 5/00, H05K 1/02, H05K 3/46

(54) **REINFORCED LAMINATED MULTI-PHASE BUSBAR AND METHOD OF MANUFACTURING THE SAME**
VERSTÄRKTE LAMINIERTE MEHRPHASIGE SAMMELSCHIENE UND VERFAHREN ZUR HERSTELLUNG DAVON
BARRE OMNIBUS MULTIPHASE LAMINÉE RENFORCÉE ET SON PROCÉDÉ DE FABRICATION

(43) Date of publication of application: 20.06.2018
(73) Proprietor: ABB Schweiz AG, 5400 Baden (CH)
(72) Inventor: Velthuis, Rudi, 79787 Lauchringen (DE); Iordanidis, Arthouros, 5400 Baden (CH); Maciocha, Dariusz, 23-400 Bilgoraj (PL); Reutlinger, Christoph, 3012 Bern (CH)
(74) Representative: Maiwald Patent- und Rechtsanwaltsgesellschaft mbH

(56) References cited:
- WO-A1-84/01861
- WO-A2-2012/135673
- DE-B4-102005 015 945
- US-A- 3 663 866
- US-A- 3 893 233
- US-A1- 2001 025 718
- US-A1- 2014 212 624
- US-B1- 6 329 603

## Description

The invention is related to a reinforced laminated multi-phase busbar and a method of manufacturing the same according to claims 1 and 9.

Multi-phase busbars are used in switchboards and/ or switchgears, in particular low voltage switchgears, to conduct and distribute alternating electrical current to different electrical devices that are usually installed in switch gear cabinets. In order to provide for the possibility to conduct all three phases or even more phases of an alternating current in a single busbar, multi-phase busbars have been developed which comprise a base layer and a cover layer of electrically insulating material between which two or more layers of conducting sheet metal, in particular copper, are arranged that are electrically insulated from each other by means of insulating intermediate layers.

The afore-described laminated busbars are described in DE 10 2005 015 945 B4 of the applicant and have the advantage that they are compact and do not tend to delaminate due to forces generated by eddy currents which are induced by the alternating electric currents which are conducted in the different conducting layers for each phase.

Laminated busbars as described in DE 10 2005 015 945 B4 have the advantage that electrical losses in the busbar system as well as the forces generated by eddy currents are reduced or even locally cancelled due to the phase shifts of the electrical current flow in each of the conducting layers.

One problem of the busbars as described in DE 10 2005 015 945 B4 are the costs involved in the lamination process itself, in which the different layers are bond to each other by means of liquid resin, like epoxy resin. As the resins used for the laminating process are usually toxic and thus require specific safety precautions for the staff involved in the production process, the production costs are high.

WO 2012/135673 A2 describes a method for manufacturing a multilayer bus bar apparatus including mapping a thin film dielectric insulating material around selected surfaces of conductive members, placing the combined assembly in a heated press, heating the combined assembly and applying pressure to plate to bond the insulating layers.

US 2014/0212624 A1 describes a fiber-reinforced member, where a mold clamping enables insert members to be clamped between upper and lower fiber-reinforced resin sheets, be plastically deformed, be pushed outward in the radial direction, and spread to the interior of an opening of a plate material.

US 3 663 866 A describes a back plane composed of several conductive layers with one connection between a given pin and any one of the conductive layers. Isolation between the pins and the electrically dissociated layers is provided by a potting compound.

According to an alternative production method which is described in a non-published co-application of the applicant, the base layer, cover layer and the intermediate insulating layers of a laminated busbar are made of a sheet molding compound (SMC) which includes a mixture of a specific polyester resin and reinforcing fibers, like cut glass fibers. The SMC material, which has been used in the production of different types of casings, e.g. casings of switchboard cabinets and the like for long, includes the polyester resin in a semi-cured form. In order to bond the different layers together, heat and high pressure are applied to the stacked layers in a heat molding press which causes the resin to liquefy and, together with the fibers, flow into openings formed in the conducting layers and adhere to the different layers when completely cured.

However, although multi-phase busbars which are manufactured on basis of SMC layers can be produced at reduced costs, the bonding of the metal (copper) to the sheet molding compound can be weak if no optimal resin formulation is used. Although there is a possibility to perform a pre-treatment of the metal, e.g. by applying chemical substances in order to roughen the metal surface and improve the bonding between metal and SMC, this known kind of chemical treatment involves the use of aggressive chemicals like acids for etching the surface which are harmful to the environment and expensive to dispose. Moreover, the usage of such chemicals requires costly safety precautions too.

Accordingly, it is a problem of the present invention to provide for a multi-phase busbar which can be produced at reduced costs without involving aggressive chemicals for treating the surface of the conducting layers, and which has an improved resistance against delamination of the metal layers and insulating layers.

This problem is solved by a laminated multi-phase busbar and a method of manufacturing the same as claimed in claims 1 and 9.

Further objects of the present invention are included in the dependent claims.

According to a first object of the present invention, a laminated multi-phase busbar for conducting electric energy comprises a base layer of an electrically insulating material, a first conducting layer of an electrically conducting material which is arranged on and mechanically connected to said base layer, and a first intermediate insulating layer of an electrically insulating material which is arranged on and mechanically bonded to said first conducting layer. The multi-phase busbar further includes at least a second conducting layer of an electrically conducting material which is arranged on and connected to the first intermediate layer and a cover layer of an electrically insulating material which is arranged on the second conducting layer. The electrically insulating material of the base layer, the intermediate layer and the cover layer is provided as a sheet molding compound which includes a thermosetting resin and reinforcing fibers. In this sandwich of layers, the electrically conducting layers are formed of sheet metal, preferably copper, which is mechanically connected to the intermediate insulating layer by means of the cured thermosetting resin. According to the invention, the first conducting layer comprises at least one first through-hole or opening which in the final product is filled with thermosetting resin and reinforcing fibers that form a material bridge which mechanically bonds the base layer to the first intermediate insulating layer thereby increasing the bonding forces between the layers without applying any surface treatment to the metal.

The generation of through-holes which may be cut or punched into the sheet metal preferably have a diameter of more than 10 mm provides for a good mechanical performance of the laminate. In a prototype testing of a sample, applicant recognized that 3 holes having a diameter of 24 mm withstood a force of 3 kN before delamination started. This means approx. 1000 N per hole before the layers started delaminating which corresponds to a pressure of approx. 2.5 MPa.

Another advantage of the invention can be seen in that the addition of a few holes to the conducting layers does not significantly change the electrical performance of the busbar.

Moreover, the invention provides for the following economic advantages:
▪ Cost-effective increase of the tensile strength as the cutting or punching of the holes can be automated easily.
▪ The cleaning of the metal (copper) is made easier as the main contribution to the bonding forces is generated by the holes. In the best case, no cleaning and therefore no additional cleaning costs are required at all.

In the preferred embodiment of the invention, the second conducting layer comprises at least one second through-hole or opening which is filled with the thermosetting resin and reinforcing fibers included in the SMC that is preferably provided in form of coils from which the material can be unwound and arranged in the afore-mentioned stacked formation. In this embodiment, the thermosetting resin and the reinforcing fibers in the at least one second through-hole form another material bridge which bonds the cover layer to the first intermediate insulating layer. As an alternative, the thermosetting resins of the SMC-material, which are in a partially cured stage, can also be provide in the form of putty-like masses, granules or preforms.

According to another aspect of the present invention, the center of said at least one first through-hole in said first conducting layer is offset of the center of said at least one second through-hole in said second conducting layer. In this embodiment, the offset between the centers of the through-holes is preferably larger than the diameter of the largest through-hole, if the through-holes in the different conducting layers have varying diameters. This provides for the advantage that the areas of two through-holes in adjacent conducting layers do not overlap and the local flow of the fluidized SMC material during the production process does not result in impressions in the surface of the neighboring insulating layers.

According to another object of the invention, the first conducting layer comprises a plurality of first through-holes each of which is filled with thermosetting resin and reinforcing fibers and which forms a material bridge which bonds said base layer to said first intermediate layer. Additionally, or alternatively, the second conducting layer may also comprise a plurality of second through-holes which are filled with thermosetting resin and reinforcing fibers in order to form a material bridge or material bridges which mechanically connect the cover layer to the first intermediate layer.

The number and the diameter of the first and second through-holes depends on the forces that are generated during short circuit.

According to another object of the present invention, the density of first and/or second through-holes per square meter can be larger in an area around the center of the first and/or second conducting layer than in an area near the opposing end portions or side portion thereof. This provides for the advantage that the deflection of the layers in the central area of the busbar which is caused by the magnetic forces acting between the conducting layers as a result of the high currents of e.g. 1000 Amps or more is reduced. Moreover, the provision of a plurality of through-holes in the conducting layer reduces the generated forces in total, because the areas inside the through-holes are not conducting any electrical current at all, and they do not generate any deflecting forces.

In the preferred embodiment of the invention, the busbar is a three-phase busbar which comprises a second intermediate layer of an electrically insulating material which is arranged on and mechanically connected/bonded to said second conducting layer. In this embodiment, a third layer of an electrically conducting material for the third electrical phase of the electric energy is arranged between said second intermediate insulating layer and said cover layer. In the same way as described herein before, also this third layer of conducting material includes at least one third through-hole or preferably a plurality thereof which in the final product is/are filled with hardened thermosetting resin and reinforcing fibers, in order to form a material bridge or material bridges bonding said second intermediate insulating layer to said cover layer. In this embodiment, the second intermediate layer is also bond to the first intermediate layer by the through-holes which are arranged in the second conduction layer.

In order to connect each phase of the multi-phase busbar to an electric power supply, at least one first pin hole is formed in the first intermediate insulating layer, the second conducting layer and the cover layer. Inside of this pin hole, which is composed by the aligned holes in each of the afore-mentioned layers, a first conducting pin is arranged which is electrically connected to the first conducting layer, e.g. by welding, clamping, a screw type connection or gluing. The first conducting pin may project out of the first pin hole above the cover layer. In order to avoid any risk of sparking, the first conducting pin has a smaller diameter than the diameter of the first pin hole, e.g. only half of the diameter of the first pin hole.

In the same way, at least one second pin hole may be formed in the cover layer only, in which a second conducting pin for conducting electric energy to the second conducting layer may be arranged, which is electrically connected to the second conducting layer and has a smaller diameter than the second pin hole.

This configuration of electrical conducting pins of a smaller diameter which extend through pin holes in the respective layers having a larger diameter provides for the advantage that the resin and reinforcing fibers can also penetrate into the free space surrounding the pins and can thereby contribute to a further increased resistance against delamination after the final curing of the resin.

The sheet molding compound preferably includes a partially cured thermally curable polyester or epoxy resin and/or chopped glass fibers or strands having a length between e.g. 0,5 mm and 5 mm.

According to yet another aspect of the present invention, a method of manufacturing the multiphase busbar described herein before comprises the method steps of:
- forming a stack including
   a) a base layer of an uncured sheet molding compound,
   b) a first conducting layer
   c) an intermediate layer of an material sheet molding compound,
   d) a second conducting layer and
   e) a cover layer of an uncured sheet molding compound,

wherein said uncured sheet molding compound includes a thermosetting resin and reinforcing fibers which are movable within said resin,
providing at least one first pin hole in said stack, said first pin hole extending from said cover layer to said first conducting layer and arranging a conducting pin contacting said first conducting layer inside said first pin hole,
providing at least one second pin hole in said stack, said second pin hole extending from said cover layer to said second conducting layer and arranging a second conducting pin contacting said second conducting layer inside said second pin hole,
providing at least one first through-hole in said first conducting layer and/or said second conducting layer,
placing said stack inside a heated mold of a press, closing said mold and applying pressure to said press for a predetermined period of time, said pressure having a level which enables the resin and the fibers to flow into said first and second pin holes and said at least one first and second through-holes which are formed in said first and/or second conducting layers, and
opening said mold and removing said cured stack from said mold, in order to allow the busbar to cool down to room temperature.

The method provided for an extremely cost effective and time efficient production of multiphase busbars having improved delamination properties without using aggressive chemicals for treating the surface of the metal included in the conducting layers.

The invention is hereinafter described with reference to the accompanying drawings. In the drawings
- Fig. 1: shows a schematic top view of the multiphase busbar according to the present invention in which the through-holes in the first conducting layer are indicated in dashed lines and the through-holes in the second conducting layer are indicated in dotted lines,
- Fig. 2a: is a schematic side view of the busbar according to the present invention during the production process right after placing the stack of layers in a heated mold and applying pressure to the SMC material, and
- Fig. 2b: is a schematic cross-sectional view of the final busbar after completely curing of the resin.

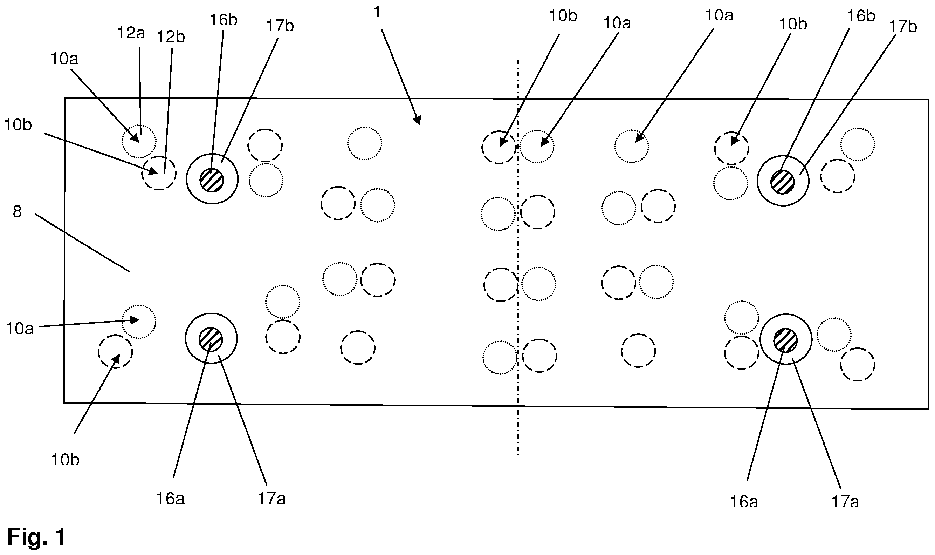

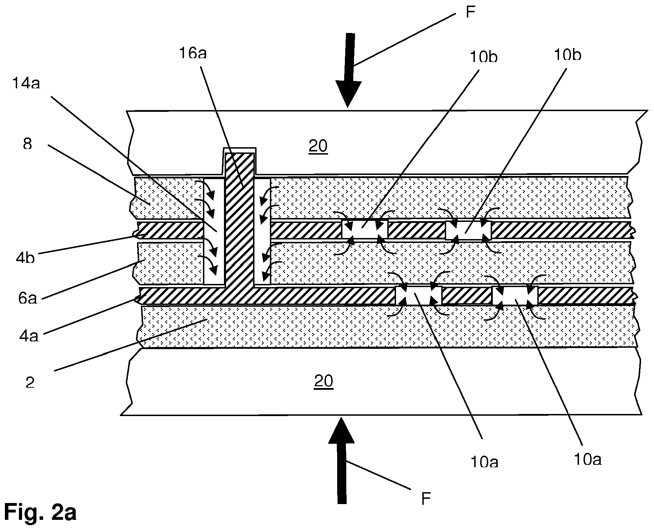

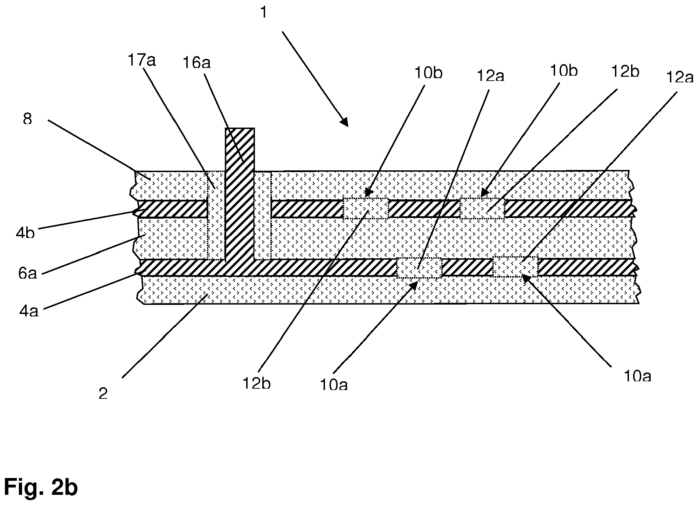

As it is shown in Figs. 1, 2a and 2b, a laminated multi-phase busbar 1 for conducting electric energy comprises a base layer 2 of an electrically insulating material, a first conducting layer 4a of an electrically conducting material which is arranged on and mechanically connected to said base layer 2, a first intermediate insulating layer 6a of an electrically insulating material which is arranged on and mechanically connected to said first conducting layer 4a, a second conducting layer 4b of an electrically conducting material which is arranged on and mechanically connected to said first intermediate layer 6 and a cover layer 8 of an electrically insulating material which is arranged on said second conducting layer 4b. The electrically insulating material of the base layer 2, the first intermediate insulating layer 6a and the cover layer 8 is a known sheet molding compound which includes a thermosetting resin, preferably a partially cured polyester resin and reinforcing fibers, whereas the material of the first conducting layer 4a and the second conducting layer 4b is a sheet metal, preferably a copper band, having a thickness of 2 to 10 mm or more. In the final product (Fig. 2b), the material of the sheet metal is mechanically connected to the first intermediate insulating layer 6a by the thermally cured thermosetting resin.

As it can be seen from figs. 1 and 2a, the first conducting layer 4a comprises at least one first through-hole 10a, and the second conducting layer comprises a second through-hole 10b which are open and not filled with any material when placing a stack of different layers in the sheet molding press 20 as it is schematically indicated in fig. 2a.

According to Figs. 1 and 2a, a first pin hole 14a is formed in the first intermediate insulating layer 6a, the second conducting layer 4b and the cover layer 8 through which a first conducting pin 16a for conducting electric energy to the first conducting layer 4a extends. The first conducting pin 16a is electrically connected to the first conducting layer 4a or may be formed integral with this layer. In the same way, a second conducting pin 16b is arranged in a second pin hole 14b which is formed in the cover layer 8. The second conducting pin 16b is electrically connected to the second conducting layer 14b (not shown), in order to conduct electric energy to said second conducting layer 14b.

As it is further indicated by arrows shown in Fig. 2a, the thermosetting resin is liquefied and the resin and the reinforcing fibers included therein flow into the first through-holes 10a and second through-holes 10b as well as into the space around the first pin 16a when applying compressive force F and heat to the stack of layers.

After the complete curing of the resin, the hardened resin and reinforcing fibers fill up the first through-holes 10a and second through-holes 10b, thereby forming material bridges 12a and 12b which bond the base layer 2 and the cover layer 8 to the first intermediate layer 6a. In the same way, the hardened resin and fibers which were pressed into the space around the first conducting pin 16a form a material bridge 17a which interlocks the first intermediate layer 6a to the cover layer 8 and at the same time electrically insulates the third conducting pin 16a from the second conducting layer 4b.

Moreover, the hardened resin which during the compression molding step was pressed into the second pin holes 14b in which the second conducting pins 16b are located forms material bridges 17b between the second conducting pins 16b and the cover layer 8 which closes the opening around the second conducting pin 16b and mechanically interlocks this second connecting pins 16b to the base layer 8.

As it can further be seen from Fig. 1, the busbar 1 of the invention preferably comprises a plurality of first through-holes 10a (indicated in dotted lines) which are arranged in the first conducting layer 4a are a plurality of second through-holes 10b (indicated in dashed lines) which are preferably located offset of the first through-holes 10a, such that the areas of the first and second through-holes do not overlap when viewed in a direction parallel to the longitudinal axis of the conducting pins 16a, 16b. As can be further seen from Fig.1, the area-density of the first and second through-holes 10a, 10b may be higher in the area around the center of the busbar 1 and may decline towards the longitudinal edges of the bus bar 1.

The first and/or second through-holes 10a, 10b may have a diameter which is larger than 10 mm and preferably lies in a range between 11 mm and 30 mm.

### Listing of reference signs

- 1: busbar
- 2: base layer
- 4a: first conducting layer
- 4b: second conducting layer
- 6a: first intermediate layer
- 8: cover layer
- 10a: first holes in first conducting layer
- 10b: second holes in second conducting layer
- 12a: material bridges in first through-holes
- 12b: material bridges in second through-holes
- 14a: first pin hole
- 14b: second pin hole
- 16a: first conducting pin
- 16b: second conducting pin
- 17a: material bridge around first conducting pins
- 17b: material bridge around second conducting pins
- 20: sheet molding press
- F: compressive force

## Claims

1. Laminated multi-phase busbar (1) for conducting electric energy, comprising a base layer (2) of an electrically insulating material,
a first conducting layer (4a) of an electrically conducting material which is arranged on and mechanically connected to said base layer (2),
a first intermediate insulating layer (6a) of an electrically insulating material which is arranged on and mechanically connected to said first conducting layer (4a), a second conducting layer (4b) of an electrically conducting material which is arranged on and mechanically connected to said first intermediate layer (6) and a cover layer (8) of an electrically insulating material which is arranged on said second conducting layer (4b), wherein said electrically insulating material of said base layer (2), said first intermediate insulating layer (6a) and said cover layer (8) is a sheet molding compound including a thermosetting resin and reinforcing fibers, and that the material of said first conducting layer (4a) and said second conducting layer (4b) is a sheet metal which is mechanically connected to the first intermediate insulating layer (6a) by said thermally cured thermosetting resin,
**wherein** said first conducting layer (4a) comprises at least one first through-hole (10a) which is filled with thermosetting resin and reinforcing fibers, said thermosetting resin and reinforcing fibers in said first through-hole (10a) forming a material bridge (12a) bonding said base layer (2) to said first intermediate insulating layer (6a).

2. Laminated multi-phase busbar according to claim 1,
**characterized in that** said second conducting layer (4b) comprises at least one second through-hole (10b) filled with thermosetting resin and reinforcing fibers, said thermosetting resin and reinforcing fibers in said at least one second through-hole (10b) forming a material bridge (12b) bonding said cover layer (8) or a second insulating layer to said first intermediate insulating layer (6a).

3. Laminated multi-phase busbar according to claim 2
**characterized in that** the center of said at least one first through-hole (10a) in said first conducting layer (4a) is offset of the center of said at least one second though-hole (10b) in said second conducting layer (4b).

4. Laminated multi-phase busbar according to claim 2 or 3,
**characterized in that** the first conducting layer (4a) comprises a plurality of first through-holes (10a) each of which being filled with thermosetting resin and reinforcing fibers forming a material bridge (12a) bonding said base layer (2) to said first intermediate layer (6a) and/or that said second conducting layer (4b) comprises a plurality of second through-holes (10b) each of which being filled with thermosetting resin and reinforcing fibers forming a material bridge (12b) bonding said cover layer (8) to said first intermediate layer (6a).

5. Laminated multi-phase busbar according to claim 4,
**characterized in that** in a central area of said first conducting layer (4a) or second conducting layer (4b), the density of first and/or second through-holes (10a, 10b) is larger than in an area near the opposing end portions of said layers (4a, 4b).

6. Laminated multi-phase busbar according to any of the previous claims,
**characterized in that** at least one first pin hole (14a) is formed in said first intermediate insulating layer (6a), said second conducting layer (4b) and said cover layer (8), and that a first conducting pin (16a) for conducting electric energy to said first conducting layer (4a) is arranged inside said first pin hole, said first conducting pin (16a) being electrically connected to said first conducting layer (4a) and having a smaller diameter than said first pin hole (14a).

7. Laminated multi-phase busbar according to any of the previous claims,
**characterized in that** at least one second pin hole (14b) is formed in said cover layer (8), and that a second conducting pin (16b) for conducting electric energy to said second conducting layer (4b) is arranged inside said second pin hole (14b), said second conducting pin (16b) being electrically connected to said second conducting layer (4b) and having a smaller diameter than said second pin hole (14b).

8. Laminated multi-phase busbar according to any of the previous claims,
**characterized in that** the first and/or second through-holes (10a, 10b) have a diameter larger than 10 mm, preferably in a range between 11 mm and 30 mm, preferably 15 to 25 mm.

9. Method of manufacturing a multi-phase busbar according to any of the preceding claims **characterized by** the following method steps:
- forming a stack including
**a)** a base layer of an uncured sheet molding compound,
**b)** a first conducting layer
**c)** an intermediate layer of an uncured material sheet molding compound,
**d)** a second conducting layer and
**e)** a cover layer of an uncured sheet molding compound,
wherein said uncured sheet molding compound includes a thermosetting resin and reinforcing fibers which are movable within said resin,
- providing at least one first pin hole in said stack, said first pin hole extending from said cover layer to said first conducting layer and arranging a conducting pin contacting said first conducting layer inside said first pin hole,
- providing at least one second pin hole in said stack, said second pin hole extending from said cover layer to said second conducting layer and arranging a second conducting pin contacting said second conducting layer inside said second pin hole,
- providing at least one first through-hole in said first conducting layer and/or said second conducting layer,
- placing said stack inside a heated mold of a press, closing said mold and applying pressure to said press for a predetermined period of time, said pressure having a level which enables the resin and the fibers to flow into said first and second pin hole and said at least one first and second through-hole in said first and/or second conducting layer, and
- opening said mold and removing said cured stack from said mold.

## Patentansprüche

1. Laminierte mehrphasige Stromschiene (1) zum Leiten elektrischer Energie, mit einer Basisschicht (2) aus einem elektrisch isolierenden Material,
einer ersten leitenden Schicht (4a) aus einem elektrisch leitenden Material, die auf der Basisschicht (2) angeordnet und mechanisch mit dieser verbunden ist,
eine erste isolierende Zwischenschicht (6a) aus einem elektrisch isolierenden Material, die auf der ersten leitenden Schicht (4a) angeordnet und mechanisch mit dieser verbunden ist, eine zweite leitende Schicht (4b) aus einem elektrisch leitenden Material, die auf der ersten Zwischenschicht (6) angeordnet und mechanisch mit dieser verbunden ist, und eine Deckschicht (8) aus einem elektrisch isolierenden Material, die auf der zweiten leitenden Schicht (4b) angeordnet ist, wobei das elektrisch isolierende Material der Basisschicht (2), der ersten isolierenden Zwischenschicht (6a) und der Deckschicht (8) eine Folienformmasse ist, die ein wärmehärtendes Harz und Verstärkungsfasern enthält, und das Material der ersten leitenden Schicht (4a) und der zweiten leitenden Schicht (4b) ein Metallblech ist, das mechanisch mit der ersten isolierenden Zwischenschicht (6a) durch das thermisch gehärtete wärmehärtende Harz verbunden ist,
wobei die erste leitende Schicht (4a) mindestens ein erstes Durchgangsloch (10a) aufweist, das mit wärmehärtendem Harz und Verstärkungsfasern gefüllt ist, wobei das wärmehärtende Harz und die Verstärkungsfasern in dem ersten Durchgangsloch (10a) eine Materialbrücke (12a) bilden, die die Basisschicht (2) mit der ersten isolierenden Zwischenschicht (6a) verbindet.

2. Laminierte mehrphasige Stromschiene nach Anspruch 1,
**dadurch gekennzeichnet, dass** die zweite leitende Schicht (4b) mindestens ein zweites Durchgangsloch (10b) aufweist, das mit wärmehärtendem Harz und Verstärkungsfasern gefüllt ist, wobei das wärmehärtende Harz und die Verstärkungsfasern in dem mindestens einen zweiten Durchgangsloch (10b) eine Materialbrücke (12b) bilden, die die Deckschicht (8) oder eine zweite Isolierschicht mit der ersten isolierenden Zwischenschicht (6a) verbindet.

3. Laminierte mehrphasige Stromschiene nach Anspruch 2
**dadurch gekennzeichnet, dass** die Mitte des mindestens einen ersten Durchgangslochs (10a) in der ersten leitenden Schicht (4a) gegenüber der Mitte des mindestens einen zweiten Durchgangslochs (10b) in der zweiten leitenden Schicht (4b) versetzt ist.

4. Laminierte mehrphasige Stromschiene nach Anspruch 2 oder 3,
**dadurch gekennzeichnet, dass** die erste leitende Schicht (4a) eine Vielzahl von ersten Durchgangslöchern (10a) aufweist, von denen jedes mit wärmehärtendem Harz und Verstärkungsfasern gefüllt ist, die eine Materialbrücke (12a) bilden, die die Basisschicht (2) mit der ersten Zwischenschicht (6a) verbindet, und/oder dass die zweite leitende Schicht (4b) eine Vielzahl von zweiten Durchgangslöchern (10b) aufweist, von denen jedes mit wärmehärtendem Harz und Verstärkungsfasern gefüllt ist, die eine Materialbrücke (12b) bilden, die die Deckschicht (8) mit der ersten Zwischenschicht (6a) verbindet.

5. Laminierte mehrphasige Stromschiene nach Anspruch 4,
**dadurch gekennzeichnet, dass** in einem zentralen Bereich der ersten leitenden Schicht (4a) oder der zweiten leitenden Schicht (4b) die Dichte der ersten und/oder zweiten Durchgangslöcher (10a, 10b) größer ist als in einem Bereich nahe den gegenüberliegenden Endabschnitten der Schichten (4a, 4b).

6. Laminierte mehrphasige Stromschiene nach einem der vorhergehenden Ansprüche, **dadurch gekennzeichnet, dass** mindestens ein erstes Stiftloch (14a) in der ersten isolierenden Zwischenschicht (6a), der zweiten leitenden Schicht (4b) und der Deckschicht (8) ausgebildet ist, und dass ein erster leitender Stift (16a) zum Leiten elektrischer Energie zu der ersten leitenden Schicht (4a) innerhalb des ersten Stiftlochs angeordnet ist, wobei der erste leitende Stift (16a) elektrisch mit der ersten leitenden Schicht (4a) verbunden ist und einen kleineren Durchmesser als das erste Stiftloch (14a) aufweist.

7. Laminierte mehrphasige Stromschiene nach einem der vorhergehenden Ansprüche,
**dadurch gekennzeichnet, dass** mindestens ein zweites Stiftloch (14b) in der Deckschicht (8) ausgebildet ist, und dass ein zweiter leitender Stift (16b) zum Leiten elektrischer Energie zu der zweiten leitenden Schicht (4b) innerhalb des zweiten Stiftlochs (14b) angeordnet ist, wobei der zweite leitende Stift (16b) elektrisch mit der zweiten leitenden Schicht (4b) verbunden ist und einen kleineren Durchmesser als das zweite Stiftloch (14b) aufweist.

8. Laminierte mehrphasige Stromschiene nach einem der vorhergehenden Ansprüche,
**dadurch gekennzeichnet, dass** die ersten und/oder zweiten Durchgangslöcher (10a, 10b) einen Durchmesser größer als 10 mm, vorzugsweise in einem Bereich zwischen 11 mm und 30 mm, vorzugsweise 15 bis 25 mm, aufweisen.

9. Verfahren zur Herstellung einer mehrphasigen Stromschiene nach einem der vorhergehenden Ansprüche, **gekennzeichnet durch** die folgenden Verfahrensschritte:
- Bilden eines Stapels mit
a) einer Basisschicht aus einer ungehärteten Folienformmasse,
b) einer ersten leitenden Schicht
c) einer Zwischenschicht aus einer ungehärteten Material-Folienformmasse
d) einer zweiten leitenden Schicht und
e) einer Deckschicht aus einer ungehärteten Folienformmasse,
wobei die ungehärtete Folienformmasse ein wärmehärtendes Harz und Verstärkungsfasern enthält, die innerhalb des Harzes beweglich sind,
- Bereitstellen mindestens eines ersten Stiftlochs in dem Stapel, wobei sich das erste Stiftloch von der Deckschicht zu der ersten leitenden Schicht erstreckt, und Anordnen eines leitenden Stifts, der die erste leitende Schicht innerhalb des ersten Stiftlochs berührt,
- Bereitstellen mindestens eines zweiten Stiftlochs in dem Stapel, wobei sich das zweite Stiftloch von der Deckschicht zu der zweiten leitenden Schicht erstreckt, und Anordnen eines zweiten leitenden Stifts, der die zweite leitende Schicht innerhalb des zweiten Stiftlochs berührt,
- Bereitstellen mindestens eines ersten Durchgangslochs in der ersten leitenden Schicht und/oder der zweiten leitenden Schicht,
- Anordnen des Stapels in einer beheizten Form einer Presse, Schließen der Form und Ausüben von Druck auf die Presse für eine vorbestimmte Zeitspanne, wobei der Druck ein Niveau hat, das es dem Harz und den Fasern ermöglicht, in das erste und zweite Stiftloch und das mindestens eine erste und zweite Durchgangsloch in der ersten und/oder zweiten leitenden Schicht zu fließen, und
- Öffnen der Form und Entfernen des gehärteten Stapels aus der Form.

## Revendications

1. Barre de distribution polyphasée stratifiée (1) destinée à conduire l'énergie électrique, comprenant une couche de base (2) d'un matériau électriquement isolant, une première couche conductrice (4a) d'un matériau électriquement conducteur qui est disposée sur et reliée mécaniquement à ladite couche de base (2), une première couche intermédiaire isolante (6a) d'un matériau électriquement isolant qui est disposée sur et reliée mécaniquement à ladite première couche conductrice (4a), une deuxième couche conductrice (4b) d'un matériau électriquement conducteur qui est disposée sur et reliée mécaniquement à ladite première couche intermédiaire (6a), et une couche de revêtement (8) d'un matériau électriquement isolant qui est disposée sur ladite deuxième couche conductrice (4b), ledit matériau électriquement isolant de ladite couche de base (2), ladite première couche intermédiaire isolante (6a) et ladite couche de revêtement (8) étant un composé de moulage en feuille comportant une résine thermodurcissable et des fibres de renforcement, et le matériau de ladite première couche conductrice (4a) et ladite deuxième couche conductrice (4b) étant une tôle métallique qui est reliée mécaniquement à la première couche intermédiaire isolante (6a) par ladite résine thermodurcissable thermodurcie,
**dans laquelle** ladite première couche conductrice (4a) comprend au moins un premier trou débouchant (10a) qui est rempli avec de la résine thermodurcissable et des fibres de renforcement, lesdites résine thermodurcissable et fibres de renforcement dans ledit premier trou débouchant (10a) formant un pont de matière (12a) assemblant ladite couche de base (2) à ladite première couche intermédiaire isolante (6a).

2. Barre de distribution polyphasée stratifiée selon la revendication 1,
**caractérisée en ce que** ladite deuxième couche conductrice (4b) comprend au moins un deuxième trou débouchant (10b) rempli avec de la résine thermodurcissable et des fibres de renforcement, lesdites résine thermodurcissable et fibres de renforcement dans ledit au moins un deuxième trou débouchant (10b) formant un pont de matière (12b) assemblant ladite couche de revêtement (8) ou une deuxième couche isolante à ladite première couche intermédiaire isolante (6a).

3. Barre de distribution polyphasée stratifiée selon la revendication 2,
**caractérisée en ce que** le centre dudit au moins un premier trou débouchant (10a) dans ladite première couche conductrice (4a) est décalé du centre dudit au moins un deuxième trou débouchant (10b) dans ladite deuxième couche conductrice (4b).

4. Barre de distribution polyphasée stratifiée selon la revendication 2 ou 3,
**caractérisée en ce que** la première couche conductrice (4a) comprend une pluralité de premiers trous débouchant (10a) dont chacun est rempli avec de la résine thermodurcissable et des fibres de renforcement formant un pont de matière (12a) assemblant ladite couche de base (2) à ladite première couche intermédiaire (6a) et/ou en ce que ladite deuxième couche conductrice (4b) comprend une pluralité de deuxièmes trous débouchant (10b) dont chacun est rempli avec de la résine thermodurcissable et des fibres de renforcement formant un pont de matière (12b) assemblant ladite couche de revêtement (8) à ladite première couche intermédiaire (6a) .

5. Barre de distribution polyphasée stratifiée selon la revendication 4,
**caractérisée en ce que,** dans une zone centrale de ladite première couche conductrice (4a) ou ladite deuxième couche conductrice (4b), la densité de premiers et/ou deuxièmes trous débouchant (10a, 10b) est plus grande que dans une zone proche des parties d'extrémité opposées desdites couches (4a, 4b).

6. Barre de distribution polyphasée stratifiée selon l'une quelconque des revendications précédentes,
**caractérisée en ce qu'**au moins un premier trou d'épingle (14a) est formé dans ladite première couche intermédiaire isolante (6a), ladite deuxième couche conductrice (4b) et ladite couche de revêtement (8), et **en ce qu'**une première broche conductrice (16a) destinée à conduire l'énergie électrique jusqu'à ladite première couche conductrice (4a) est disposée à l'intérieur dudit premier trou d'épingle, ladite première broche conductrice (16a) étant reliée électriquement à ladite première couche conductrice (4a) et ayant un plus petit diamètre que ledit premier trou d'épingle (14a).

7. Barre de distribution polyphasée stratifiée selon l'une quelconque des revendications précédentes,
**caractérisée en ce qu'**au moins un deuxième trou d'épingle (14b) est formé dans ladite couche de revêtement (8), et **en ce qu'**une deuxième broche conductrice (16b) destinée à conduire l'énergie électrique jusqu'à ladite deuxième couche conductrice (4b) est disposée à l'intérieur dudit deuxième trou d'épingle (14b), ladite deuxième broche conductrice (16b) étant reliée électriquement à ladite deuxième couche conductrice (4b) et ayant un plus petit diamètre que ledit deuxième trou d'épingle (14b).

8. Barre de distribution polyphasée stratifiée selon l'une quelconque des revendications précédentes,
**caractérisée en ce que** les premiers et/ou deuxièmes trous débouchant (10a, 10b) ont un diamètre supérieur à 10 mm, de préférence dans une gamme comprise entre 11 mm et 30 mm, de préférence de 15 à 25 mm.

9. Procédé de fabrication d'une barre de distribution polyphasée selon l'une quelconque des revendications précédentes **caractérisé par** les étapes de procédé suivantes :
- former un empilement comportant
a) une couche de base d'un composé de moulage en feuille non durci,
b) une première couche conductrice,
c) une couche intermédiaire d'un composé de moulage en feuille non durci,
d) une deuxième couche conductrice, et
e) une couche de revêtement d'un composé de moulage en feuille non durci,
ledit composé de moulage en feuille non durci comportant une résine thermodurcissable et des fibres de renforcement qui sont mobiles à l'intérieur de ladite résine,
- ménager au moins un premier trou d'épingle dans ledit empilement, ledit premier trou d'épingle s'étendant de ladite couche de revêtement à ladite première couche conductrice, et placer une broche conductrice en contact avec ladite première couche conductrice à l'intérieur dudit premier trou d'épingle,
- ménager au moins un deuxième trou d'épingle dans ledit empilement, ledit deuxième trou d'épingle s'étendant de ladite couche de revêtement à ladite deuxième couche conductrice, et placer une deuxième broche conductrice en contact avec ladite deuxième couche conductrice à l'intérieur dudit deuxième trou d'épingle,
- ménager au moins un premier trou débouchant dans ladite première couche conductrice et/ou ladite deuxième couche conductrice,
- placer ledit empilement à l'intérieur d'un moule chauffé d'une presse, fermer ledit moule et appliquer une pression à ladite presse pendant un laps de temps prédéterminé, ladite pression ayant un niveau qui permet à la résine et aux fibres de s'écouler à l'intérieur dudit premier et deuxième trou d'épingle et dudit au moins un premier et deuxième trou débouchant dans ladite première et/ou deuxième couche conductrice, et
- ouvrir ledit moule et retirer ledit empilement durci dudit moule.
